# EUROPEAN PATENT APPLICATION

(11) **EP 1 347 570 A1**
(43) Date of publication of application: **24.09.2003**
(21) Application number: 02290695.2
(22) Date of filing: 20.03.2002
(51) Int. Cl.: H03F 1/30

(54) **Temperature-stable bias circuit for an integrated circuit field-effect transistor**

(71) Applicant: MOTOROLA, INC., Schaumburg, IL 60196 (US)
(72) Inventor: Bouisse, Gérard, 31100 Toulouse (FR)
(74) Representative: Wharmby, Martin Angus

(57) **Abstract**

An integrated circuit device including a first RF power field-effect transistor (T3) having a gate, and biasing means (14) for applying a bias voltage (V_{gs}) to the gate. The biasing means (14) includes a second field-effect transistor (T1) biased by resistors (R1, R2, R3) so that the quiescent current ((I_{ds})_{Q}) of the second transistor (T1) is substantially independent of chip temperature (operation at the zero-temperature-coefficient point). The biasing means (14) also includes a third field-effect transistor (T2) biased by a voltage that is a fraction of the bias voltage applied to the second transistor gate (T1) and is a function of quiescent current ((I_{ds})_{Q}) flowing through the second and third transistors (T1, T2), the bias voltage applied to the first transistor gate (T3) being a function of the bias voltage applied to the third transistor gate (T2).

The transistors (T1, T2, T3) and resistors (R1, R2, R3, R4) are formed on and in a common integrated circuit substrate and the dispersion of the characteristics due to production batch variations is low.

The biasing circuit provides a high performance in temperature stability without large extra semiconductor substrate area and without requiring external components.

## Description

### Field of the invention

This invention relates to an integrated circuit device comprising a temperature-stable bias circuit for a field-effect transistor, that is to say a transistor in which the output current between two current flow terminals is controlled by a variable electric field produced by a voltage applied to a gate terminal of the transistor.

### Background of the invention

Field-effect transistors are widely used in integrated circuits for a variety of applications. The quiescent current of a field-effect transistor is the current flowing between its current flow terminals, often referred to as source and drain terminals, when the signal applied to the terminal is zero; the quiescent current is set by a bias voltage applied to its gate electrode.

The quiescent current is a critical parameter for many applications. For example, the performance of a radio frequency ('RF') power amplifier comprising field-effect transistors, especially its gain and linearity, is very closely related to the absolute value of the quiescent current of each power transistor, and its control versus temperature.

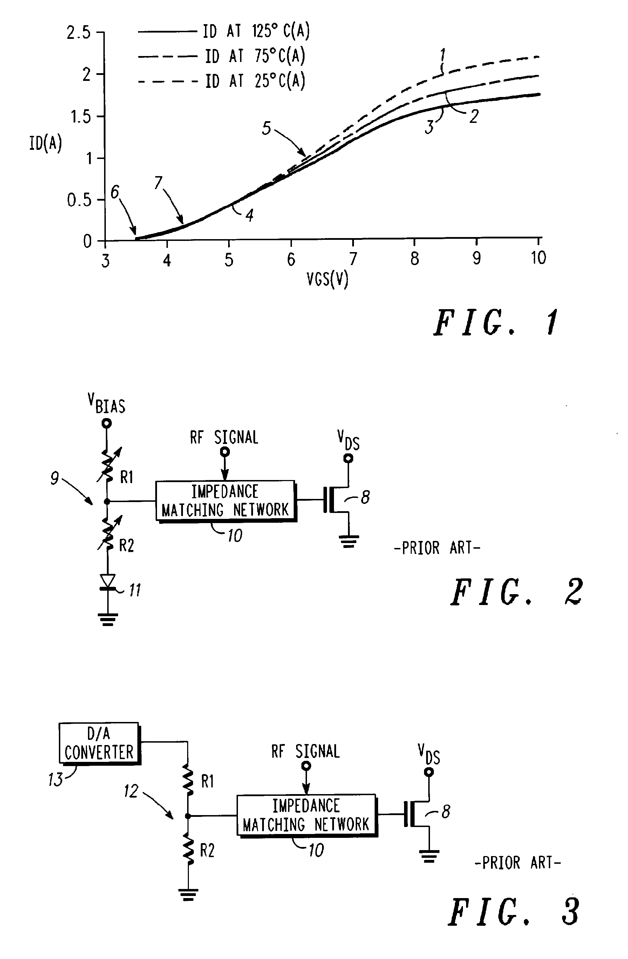

Figure 1 of the accompanying drawings shows typical characteristics of a field-effect transistor for an RF power amplifier, the drain current I_{d} being plotted against the source-gate voltage V_{gs} for chip temperatures of 25°C at 1, 75°C at 2 and 125°C at 3.

It will be seen that the current gain (or trans-conductance) of the transistor, that is to say the gradient ^{*dI*_{*d*}}/_{*dV*_{*gs*}} of its characteristic, is a function of temperature. Moreover the characteristics are non-linear; the degree of non-linearity is a function of the bias voltage and is temperature-dependent, except only if the transistor is operated with a bias voltage at the zero-temperature-coefficient ('ZTC') point 4, where the characteristics cross each other.

Different classes of operation of field-effect transistors are identified, reflecting different trade-offs between linearity, efficiency and stability. Class A operation corresponds to a gate-source bias voltage V_{gs} such that the quiescent drain current (I_{d})_{Q} is approximately 50%(I_{d})ₘₐₓ, as shown at 5 in Figure 1, and represents the best linearity and stability but poor efficiency. Class B operation corresponds to biasing such that (I_{d})_{Q} is about 1%(I_{d})ₘₐₓ, as shown at 6 in Figure 1, and represents the best efficiency but poor linearity and stability, while Class AB operation is a compromise, with biasing such that (I_{d})_{Q} is between about 2%(I_{d})ₘₐₓ and 10%(I_{d})ₘₐₓ, as shown at 7 in Figure 1,. The quiescent drain current (I_{d})_{Q} at the ZTC point 4 corresponds to approximately 25%(I_{d})ₘₐₓ in the transistor illustrated by way of example.

In the operational region of biasing a large variability of the quiescent current occurs (for a given V_{gs}):
- from part to part, because of process variation and
- in operation of a given part as a function of chip temperature.

A common approach to minimising the dispersion due to process variation is to adjust the quiescent current during manufacturing or assembly, either by the chip manufacturer or by his customer. This operation is time-consuming during manufacture and assembly and is costly.

One approach to minimising the variation of the quiescent current with chip temperature is shown in Figure 2. In the bias circuit of Figure 2, a field-effect transistor 8 forms part of an RF amplifier, its drain terminal being connected to a voltage supply V_{ds} and its source terminal being connected to ground. A bias voltage is applied through a voltage divider network 9 and an impedance matching network 10 to the gate of the transistor 8. The impedance matching network separates the DC bias voltage from the RF signal applied to the gate.

The voltage divider 9 comprises the series connection of resistors R1 and R2 and a temperature sensitive device such as a diode 11. The interconnection of the resistors R1 and R2 is connected through the impedance matching network 10 to the gate of the transistor 8. The resistances of the resistors R1 and R2 are adjusted during manufacturing, for example by laser trimming or by a manual operation, so as to compensate for in-process dispersion of their values and of the transistor characteristics. The temperature sensitive device 11 provides thermal tracking. It will be appreciated that trimming the resistors R1 and R2 involves costly additional manufacturing operations and the thermally sensitive device 11 represents an external device with corresponding size and cost implications.

In the approach illustrated in Figure 3, the bias voltage applied through the impedance matching network 10 to the transistor 8 is produced by a voltage divider 12 comprising the series connection of resistors R1 and R2, whose interconnection is connected to the impedance matching network 10. A digital to analogue converter ("DAC") 13 controls the voltage applied to the voltage divider 12. The DAC 13 is controlled to set the normal value of the bias voltage V_{gs}, and hence of the quiescent current (I_{ds})_{Q} of the transistor 8. The DAC 13 may also include temperature sensitive control by an input from a temperature sensor or, alternatively, a temperature sensitive element may be included in the voltage divider 12, as in the approach of Figure 2. It will be appreciated that this approach involves a dedicated DAC and also a controller with software to run it. These elements represent a substantial on-cost.

### Summary of the invention

The present invention provides an integrated circuit device comprising a bias circuit for a field-effect transistor as described in the accompanying claims.

### Brief description of the drawings

Figure 1 is a graph of typical characteristics of an RF power amplifier field-effect transistor,
Figure 2 is a block schematic diagram of a known type of bias circuit for a field-effect transistor,
Figure 3 is a block schematic diagram of another known type of bias circuit for a field-effect transistor,
Figure 4 is a block schematic diagram of a bias circuit for a field-effect transistor in accordance with one embodiment of the invention, given by way of example, and
Figure 5 is a schematic diagram of an impedance matching network in the bias circuit of Figure 4.

### Detailed description of the preferred embodiments

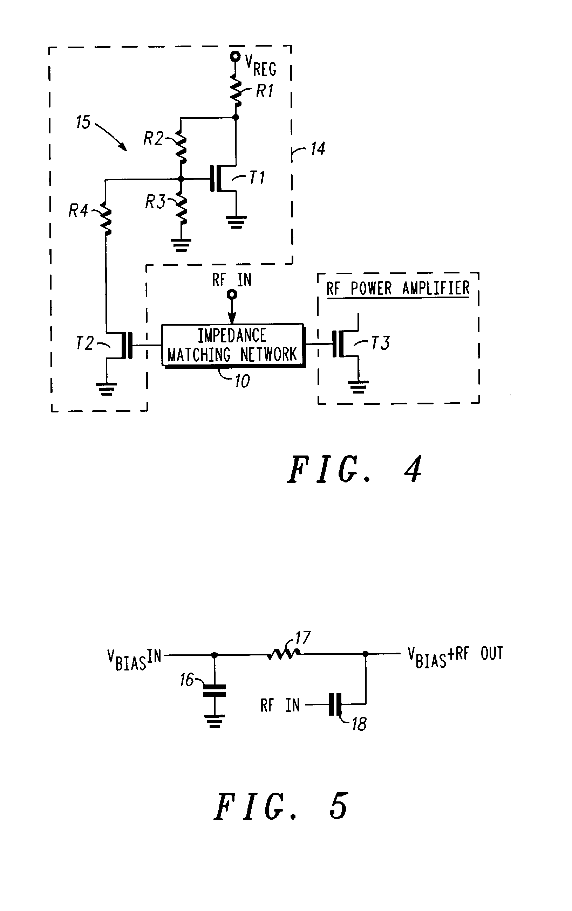

The embodiment of the present invention shown in Figure 4 comprises a bias circuit 14 for applying a bias voltage through an impedance matching network 10 to a transistor T3, comparable to the transistor 8 shown in Figures 2 and 3, and forming part of an RF power amplifier. The bias circuit 14 comprises field-effect transistors T1 and T2, which are formed on the same semiconductor integrated circuit substrate as transistor T3, and by the same process.

The drain of the transistor T1 is connected through a resistor R1 to a controlled voltage source that supplies a voltage V_{reg} and the source of the transistor T1 is connected to ground. A first voltage divider 15 comprising the series connection of resistors R2 and R3 is connected between the drain of the transistor T1 and ground, in parallel with the current flowing through the transistor T1. The interconnection between the resistors R2 and R3 is connected to the gate of the transistor T1.

The drain of the transistor T2 is connected through a resistor R4 to the interconnection of resistors R2 and R3. The source of the transistor T2 is connected to ground and its gate is connected to its drain so that the transistor T2 functions as a bi-polar diode. The drain of transistor T2 is connected to supply the bias voltage for the gate of transistor T3 through the impedance matching network 10.

In operation, the voltage divider 15 biases the gate of transistor T1 so that its quiescent current (I_{ds})_{Q} is at the zero-temperature coefficient point and therefore is substantially independent of die temperature. The quiescent current (I_{ds})_{Q} flows through the resistor R1, so that the voltage applied to the voltage divider 15 is a function of the quiescent current (I_{ds})_{Q} and the bias voltage on the transistor T1 is accordingly self-regulated.

This self-regulated voltage is also applied to the series connection of resistor R4 and transistor T2, the transistor T2 acting to compensate for the effect on the quiescent current of transistor T3 of variations in the temperature of the chip in which the transistors are all formed.

The impedance matching network 10 may be of any suitable kind. An example shown in Figure 5 comprises a capacitor 16 connected between the drain of transistor T2 and ground, a resistor 17 connected in series between the drain of transistor T2 and the gate of transistor T3 and a capacitor 18 connected in series between the gate of transistor T3 and the RF signal input. Alternatively, the resistor 17 may be replaced by an inductor, for example.

In this preferred embodiment of the invention, the transistors T1, T2 and T3 and the resistors R1, R2, R3 and R4 are all formed on the same semiconductor substrate so that they are similarly affected by manufacturing process variations (layer characteristics and thicknesses, for example). The impedance matching network 10 may also conveniently be formed in the same integrated circuit substrate.

In operation, the self-biasing configuration of transistor T1 including resistors R1, R2 and R3 ensure that the transistor T1 is biased to the zero-temperature-coefficient point of its characteristics shown at 4, in Figure 1. Accordingly its gate voltage V_{gs} will not vary substantially with temperature. The self-biasing configuration reduces dispersion of the bias voltage at the gate of transistor T1 due to process variations.

The transistor T3 is to function in Class AB functioning. The series connection of resistor R4 and transistor T2 between ground and the interconnection of resistors R2 and R3 reduces the voltage applied to the gate of transistor T1 to a voltage suitable for Class AB operation of the transistor T3.

In a particular example of a biasing circuit in accordance with this embodiment of the invention, the control Voltage V_{reg} is 15 volts, the voltage V_{ds} at the drain of transistor T1 is approximately 7.5 volts, the voltage V_{gs} at the interconnection of resistors R2 and R3 and applied to the gate of transistor T1 is approximately 5 volts and the voltage V_{ds} at the drain of transistor T2 and applied to the gate of transistor T3 is approximately 4 volts. By way of illustration, in this example, the values of the resistors R1 = 424Ω, R2 = 253Ω, R3 = 574Ω and R4 = 1295Ω.

It will be appreciated that the bias circuit of Figure 4 may be used to bias more than one field-effect transistors in the amplifier, all the biased transistors preferably being formed in the same substrate.

This embodiment of the invention is particularly applicable to generating bias voltages for RF power amplifier field-effect transistors but it is also applicable to generating bias voltages for field-effect transistors in other applications. The integrated circuit including the main transistor and the biasing circuit may be in silicon, in metal oxide silicon ("MOSFET") technology, especially lateral diffusion ("LDMOS") technology. This embodiment of the invention is also particularly applicable to field-effect transistors in GaAs semiconductor material as well as other semiconductor materials in a variety of technologies that exhibit a zero-temperature-coefficient point.

It is possible to include additional means for stabilising the bias voltage of the power transistor, if a finer control of its operational characteristics is desired. However, it will be appreciated that the embodiment of the present invention described gives excellent stability of the bias voltage without any additional means. In particular, it is normally unnecessary to trim or otherwise adjust a voltage divider chain and it is possible to avoid adding external temperature components for thermal stability, as in the approach of Figure 2, or a controller, as in the approach of Figure 3.

It will also be appreciated that the transistors T1 and T2 are not power transistors and the resistors R1, R2, R3 and R4 do not carry high levels of current so that the bias circuit 14 occupies little area on the integrated circuit. Since it is manufactured by the same process as the power amplifier transistor T3 its additional cost is very low. Moreover, the thermal tracking function is extremely rapid and therefore offers a high performance solution.

## Claims

1. An integrated circuit device including a first field-effect transistor (T3) having a gate, and biasing means (14) for applying a bias voltage (V_{gs}) to said gate,
**characterised in that** said biasing means (14) includes a second field-effect transistor (T1) having a gate and current flow terminals, and second transistor biasing means (15) for applying a bias voltage (V_{gs}) to said second transistor gate such that the quiescent current ((I_{ds})_{Q}) of said second transistor (T1) is substantially independent of chip temperature, the bias voltage applied to said first transistor gate being a function of said bias voltage applied to said second transistor gate.

2. An integrated circuit device as claimed in claim 1, wherein said biasing means (14) includes a third field-effect transistor (T2) having a gate and current flow terminals, and third transistor biasing means for applying a bias voltage (V_{gs}) to said third transistor gate (T2) that is a fraction of said bias voltage applied to said second transistor gate (T1) and is a function of quiescent current ((I_{ds})_{Q}) flowing through said third transistor (T2), the bias voltage applied to said first transistor gate (T3) being a function of said bias voltage applied to said third transistor gate (T2).

3. An integrated circuit device including a first field-effect transistor (T3) having a gate, and biasing means (14) for applying a bias voltage to said gate,
**characterised in that** said biasing means includes second and third field-effect transistors (T1, T2) having respective gates and current flow terminals, controlled voltage means for generating a controlled voltage (V_{reg}), a first resistive element (R1) connected in series with said current flow terminals of said second field-effect transistor (T1) across said controlled voltage means (V_{reg}), a voltage divider (15) comprising a series connection of second and third resistive elements (R2, R3) connected in parallel with said current flow terminals of said second field-effect transistor (T1), an interconnection between said second and third resistive elements (R2, R3) being connected to said second transistor gate (T1) so as to maintain said second transistor at or near the zero-temperature-coefficient point (4) in operation, a fourth resistive element (R4) connected in series with the current flow terminals of said third field-effect transistor (T2) to said interconnection between said second and third resistive elements (R2, R3) said third resistive element so that an interconnection between said fourth resistive element (R4) and the current flow terminals of said third field-effect transistor (T2) is maintained at a voltage related to but lower than said bias voltage of said second field-effect transistor (T1), and means for applying to said gate of said first field-effect transistor (T3) a bias voltage related to said voltage of said interconnection between said fourth resistive element (R4) and the current flow terminals of said third field-effect transistor (T2).

4. An integrated circuit device as claimed in claim 3, wherein and said gate and a current flow terminal of said third field-effect transistor (T2) are interconnected so that said gate of said third field-effect transistor is maintained at a bias voltage related to but lower than said bias voltage of said second field-effect transistor (T1).

5. An integrated circuit device as claimed in any preceding claim, wherein said transistors (T1, T2, T3) are formed on and in a common integrated circuit substrate.

6. An integrated circuit device as claimed in claim 5, wherein said resistors (R1, R2, R3, R4) are formed on and in said common integrated circuit substrate.
